# EUROPEAN PATENT SPECIFICATION

(11) **EP 2 744 054 B1**
(45) Date of publication and mention of the grant of the patent: **07.02.2018**
(21) Application number: 12196474.6
(22) Date of filing: 11.12.2012
(51) Int. Cl.: H01S 5/022, H01S 5/042, H05K 1/02, H01S 5/062, H01S 5/42, G02B 6/42

(54) **Interconnect structure for coupling an electronic unit and an optical unit, and optoelectronic module**
Verbindungsstruktur zur Kopplung einer elektronischen Einheit und einer optischen Einheit sowie optoelektronisches Modul
Structure d'interconnexion pour coupler une unité électronique et une unité optique et module optoélectronique

(43) Date of publication of application: 18.06.2014
(73) Proprietor: Tyco Electronics Svenska Holdings AB, 17526 Järfälla (SE)
(72) Inventor: Kaikkonen, Andrei, 17548 Järfälla (SE); Lundqvist, Lennart Per Olof, 17760 Järfälla (SE); Svensson, Lars-Göte, 19133 Sollentuna (SE); Lindberg, Peter, 75229 Uppsala (SE)
(74) Representative: Grünecker Patent- und Rechtsanwälte PartG mbB

(56) References cited:
- EP-A2- 1 130 812
- US-A1- 2003 052 380
- US-A1- 2005 169 327
- US-A1- 2010 172 609

## Description

The present invention relates to an interconnect structure for coupling an electronic unit for outputting and/or receiving electric signals, and an optical unit for converting said electric signals into optical signals and/or vice versa. The present invention also relates to an optoelectronic module comprising such an interconnect structure.

In order to support the communication requirements of high-speed data transmission applications (for instance at bit rates of 25 Gbps) optical links are used as an alternative to merely electrical wire based interconnection. Currently, manufacturers produce products such as modules for optical interconnects and so-called optical cables. In this context, an optical module may be a transmitter (i.e. comprising a light source for transmitting an optical data signal), a receiver (i.e. comprising a photo detector for receiving an optical signal) or a transceiver, which is a combined receiver and transmitter.

Often, modules come with a connector for connecting one or more optical fibers for transporting the optical data signal. In an optical cable the module and fiber is typically preconnected. It is also possible to have the module or the components of the module mounted directly on a circuit board, such as a motherboard for a computer, for example for interconnects in a supercomputer or as a connection to peripheral equipment.

In the context of the present invention an optoelectronic module refers in general to a system comprising optoelectronic components for transmitting or receiving an optical signal connected to driver and/or receiver electronics. Optoelectronic components are in the present context devices arranged to convert electrical energy into optical energy or optical energy into electrical energy, i.e. light sources and photo detectors, such as laser diodes and photo diodes. Often the laser diodes are so-called vertical cavity surface emitting lasers (VCSEL) and as photo diodes p-intrinsic-n photo diodes may be used.

Typically, such a module will also comprise an interface allowing the module to be connected to one or more optical fibers as well as control electronics to adjust the operating parameters of optoelectronic components. For example, the operation of a laser diode typically requires an adjustable bias current, modulations current and optionally pre-emphasize. Often, such modules will support more than one channel, such as 2, 4, 8, 12 or 16 channels, but any number of channels is conceivable depending on the application. For such a use the light sources and photo detectors are often available in arrays, such as 1 xN arrays or 2xN arrays, wherein N is a positive integer. Strictly, a 2xN array is referred to as a matrix, but in order to simplify notation only the term "array" is used in the following.

In order to convert an electrical data signal into a signal suitable for driving a light source to emit an optical signal comprising this data signal, a driver circuit is required. Similarly, a receiver circuit is required to convert received optical signals into an electrical signal suitable for further transmission in the system. Such driver and receiver circuits are well known in the art and they are typically provided as integrated circuits either as driver chips (comprising driver circuits), transmitter chips (comprising driver circuits), or transceiver chips (comprising a driver and receiver circuit).

A receiver chip may often also be referred as a TIA chip (transimpedance amplifier chip) or a LIA chip (limiting impedance amplifier chip). The chips comprise data pins/pads for receiving/transmitting the electrical data signal to/from a host system and connecting pads for connecting to the optical devices, i.e. connecting pins/pads for connecting to the optical side of the chip, i. e. light sources or photo detectors.

In all data transmission systems, signal integrity is a key issue. Due to the high data rates in recently developed communication systems having data transmission rates of e. g. 25 Gbps, signal integrity, such as for instance the reduction of cross-talk between signal lines, has become a major concern.

Ideally, an interconnection system will carry signals without distortion. One type of distortion is called cross-talk. Cross-talk occurs when one signal creates an unwanted signal on another signal line. Generally, cross-talk is caused by electromagnetic coupling between signal lines. Therefore, cross-talk is a particular problem for high-speed, high-density interconnection systems. Electromagnetic coupling increases when signal lines are closer together or when the signals they carry are of a higher frequency. Both of these conditions are present in a high-speed, high-density interconnection system.

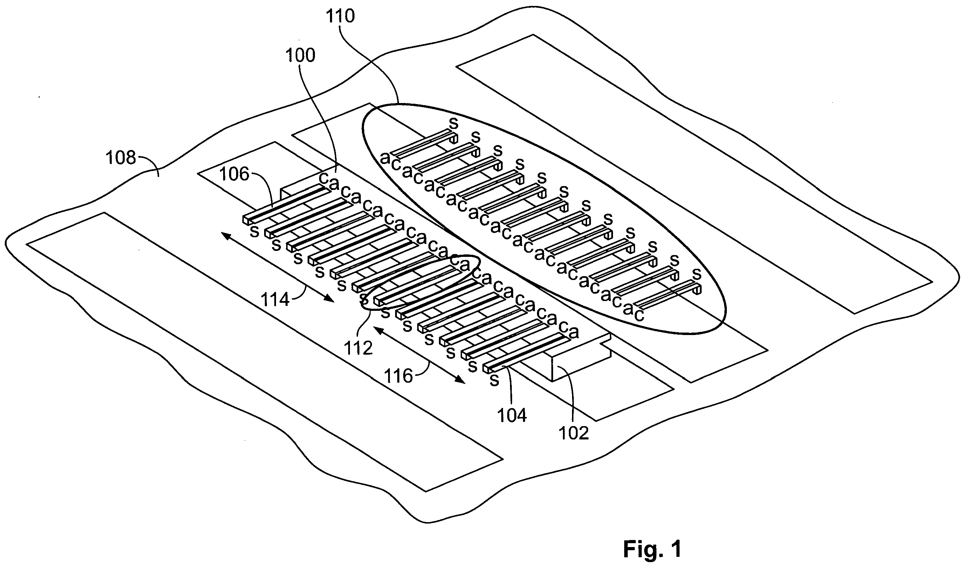

In particular for high-frequency applications, the interconnect structure that is provided to connecting the optical components and the electronic components to each other will have significant impact on the signal integrity. Figure 1 shows an example of an interconnection between a driver circuitry and a VCSEL array 100 as it might be used for a so-called E/O engine (electro-optic engine) which is suitable for converting electric signals into optical ones. The example of Figure 1 shows a 12-channel topology with a 12 channel VCSEL array 100 being mounted in an electrically conductive substrate 102. Each of the array's diodes has a cathode and an anode (marked as c and a terminals in Figure 1) which are connected by means of edge coupled transmission lines or bond wires 104 to a driver circuitry.

In particular, these interconnecting lines are formed in pairs and each pair comprises a signal line 104 (denoted with s) and a ground line 106. As shown in Figure 1, each of the ground lines 106 are connected to a ground plane layer 108. An example for a technical implementation of this schematic arrangement is given in the Reference Design IPVD12G011-ULM850-10-TT-N0104U rev.04 released June 17, 2009, by Philips Technologie GmbH U_L_M Photonics und IPtronics A/S (to be downloaded from the internet URL http://iptronics.com/files/14774/IPBVD12G011_ULM_RefDesign.04.pdf).

The module shown in Figure 1 moreover has an array of further interconnects 110 for connecting a PIN diode array to a belonging amplifier (TIA) also located on the circuit carrier of Figure 1.

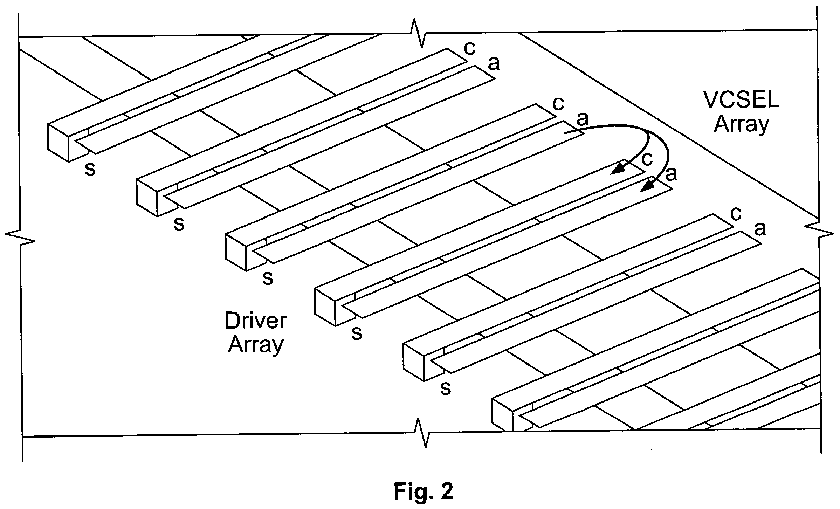

When considering the channel number 7 (marked with reference numeral 112) as a victim, and the remaining channels 114, 116 as the transmitter signal aggressors, it can be found that the cross talk, which is generated by this configuration, amounts to 4 ps or 0.1 UI jitter in an EYE diagram at a 25 Gbps bit rate and a bit error rate (BER) of 10⁻¹². Since the VCSEL are placed on a highly conductive substrate, the high coupling and cross talk between neighboring driver VCSEL channels can be attributed to the fact that the impedance of the return current trace is similar to the impedance of a signal trace for the neighbouring channel. Thus, significant amount of the aggressor return current is forced to pass through the VCSEL of the victim channel, thereby generating a high level of cross talk. This effect is illustrated schematically in Figure 2.

US 2003/052380 A1 discloses a carrier for an optical device wherein the optical device is mounted on a ground plane and bond-connected to a signal line which has an integrated resistance formed as a part of the metallization lead of the signal line. The connection to the ground line seems to be effected by the direct connection of the chip onto the ground layer. The ground patch GND1, whereon the laser diode is mounted, also serves as a heat sink for the heat that is generated by the laser diode. For connecting this carrier to another electronic component, for instance a driver circuit, two input terminals are arranged along the edge of the carrier, whereby the input terminal T1 forms an extremity of an elongated conductor that is connected to the resistor at the other extremity of the elongated conductor. The input terminal T2, on the other hand, forms an extremity of an elongated input ground patch that is connected to the first ground patch GND1 at the other extremity on the upper planar surface of the substrate.

US 2005/169327 A1 relates to a method and apparatus reducing electrical and thermal crosstalk of a laser array. According to this document, a laser array includes a plurality of lasers and a plurality of dissipation elements. These dissipation elements are interstitial to the lasers and can be implemented as non-lasing diodes. These dissipation elements are selectively activated to adjust the temperature at the laser junctions. Figures 6A and 6B of this document show a laser chip module with a laser array and a multi-layer circuit assembly for providing the drive signals for the lasers and dissipation elements within the laser array. In a first layer, RF/DC transmission lines are provided to carry the RF modulation signals from laser driver circuits. For shielding reasons, each RF/DC transmission line is bounded on both sides by ground lines that are also implemented as traces on the substrate having via holes through the substrate to a backside ground plane.

US 2010/172609 A1 generally relates to a method to improve signal-to-noise ratio in high-speed optical data communications and in particular discloses an optoelectronic integrated circuit board that carries optoelectronic components and can be connected to a further printed circuit broad for contacting a receiver (TIA Chip). The ICB can be connected to an array of optical fibres and carries VCSEL diodes and photo detectors for transforming electrical into optical signals, and optical into electrical signals. In paragraph [0047] of document D3, it is mentioned that in order to avoid signal reflections which degrade high-speed signal integrity, transmission lines connecting the 1x4 common cathode PD array die on the ICB to the receiver TIA chip are designed as matched transmission lines with controlled impedance of 50 Ω single-ended or 100 Ω differential.

EP 1 130 812 A2 relates to a high-speed modulation system utilizing a field effect to confine a signal path. In to this document, an arrangement is disclosed in which the signal return path is confined relative to the energizing signal path by a field effect in a common conductor extending under the signal path

Consequently, the problem underlying the present invention is to provide an interconnect structure and a belonging optoelectronic module, whereby the signal integrity can be improved in a particularly simple and cost-efficient way.

This object is solved by the subject matter of the independent claims. Advantageous embodiments of the present invention are the subject matter of the dependent claims.

The present invention is based on the idea that by modifying the impedance of the return path for the driver-VCSEL interconnect in a way that it is significantly lower than that of the signal path, a significantly lower amount of the aggressor return current passes through the VCSEL of any victim channel.

In particular, the present invention proposes an interconnect structure for coupling an electronic unit for outputting and/or receiving electric signals, and an optical unit for converting said electric signals into optical signals and/or vice versa, said interconnect structure comprising an electrically insulating substrate and at least one pair of transmission leads to be coupled between the electronic unit and the optical unit, a first lead being operable as a signal line, and a second lead being operable as a ground line. According to the present invention the second lead is formed to have a lower impedance than the first lead.

Specifically, the second lead has a width that is larger than a width of the first lead. This reduces the impedance of the ground line with respect to the signal line. In particular, the ground line width is at least five times wider than the width of the signal line. Furthermore, the interconnect structure usually also possesses a ground plane layer buried within the electrically insulating substrate.

According to an advantageous embodiment of the present invention, the second leads, which are operable as ground lines, are connected to this ground plane layer by means of via holes. Due to process limitations, the ground plane layer often cannot be made thicker than the skin depths corresponding to the fundamental frequency bit rate. Therefore, the via holes may be non-ideal and the ground line cannot always be kept wide enough over the entire distance from the VCSEL to the driver array ground.

Consequently, a combination of broad ground line dimensions and a connection to the ground plane layer may be employed to achieve best results. The signal lines' impedance, which is typically in the order of 50 Ohm, on the other hand, is mainly controlled by their width and their distance to the ground plane layer.

With the an arrangement according to the present invention, the impedance for a signal return path can be significantly reduced and a lower amount of aggressor return current passes through the VCSEL of the victim channel, thus improving signal integrity.

Specifically, the signal line may have a width of 20 µm, whereas the ground line has a width of around 110 µm. Preferably, the ground lines are connected to an underlying ground plane layer by means of a via structure.

The interconnect structure according to the present invention may either be formed to directly mount driver electronic circuitry thereon or alternatively, may also be formed to mount respective electric connectors thereon. This may for instance be a so-called QSFP connector (Quad Small Form-factor Pluggable) as offered for instance by the firm TE Connectivity.

According to the present invention, an optoelectronic module based on the electrical interconnect structure has an optical unit, such as a VCSEL array, with an electrically conducting substrate that can be connected to a ground plane layer of the interconnect structure. This topology leads to a particularly efficient cross talk suppression by choosing the impedance ratio of the signal and ground line according to the present invention.

The accompanying drawings are incorporated into and form a part of the specification to illustrate several embodiments of the present invention. These drawings together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. Further features and advantages will become apparent from the following more particular description of the various embodiments of the invention, as illustrated in the accompanying drawings, in which like references refer to like elements, and wherein:
- **Figure 1**: shows an optoelectronic module with interconnects having essentially equal impedance;
- **Figure 2**: shows a detail of Figure 1 for illustrating the cross talk effects;
- **Figure 3**: shows a schematic perspective representation of an E/O engine according to the present invention;
- **Figure 4**: shows a detail of Figure 3;
- **Figure 5**: an s-parameter coupling coefficient vs. frequency curve corresponding to the strongest cross talk from driver output to the neighbouring channel VCSEL input obtained from the arrangement of Figure 1;
- **Figure 6**: an s-parameter coupling coefficient vs. frequency curve for the arrangement of Figure 3;
- **Figure 7**: **a** 25 Gbps EYE diagram for a Driver-VCSEL channel with all aggressor channels activated, for the arrangement of Figure 1;
- **Figure 8**: an EYE diagram for the arrangement of Figure 3.

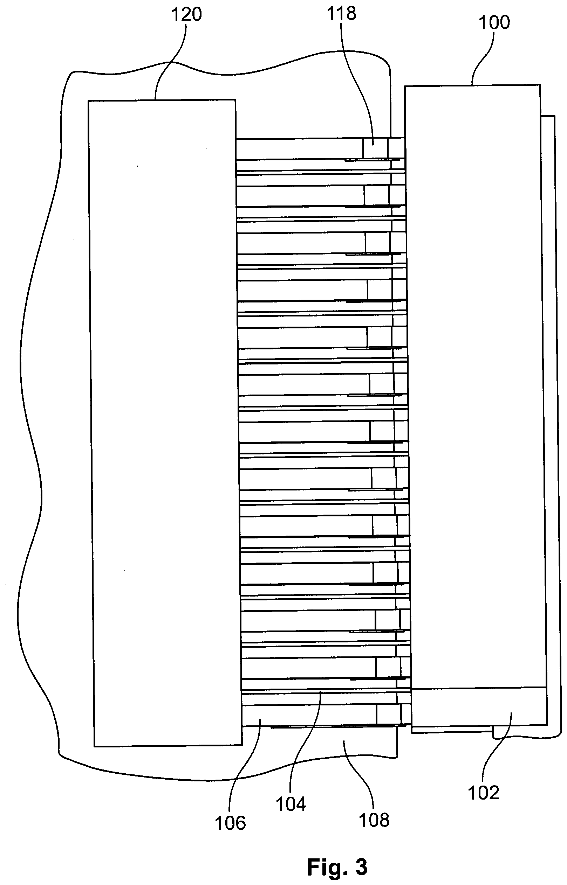

Referring now to Figure 3, a first advantageous embodiment of an optoelectronic module which has an interconnect structure according to the present invention is shown.

In the figures of the present application, the electrically insulating parts of the circuit carrier are not shown in order to more clearly illustrate the electric connections between the conductive parts.

However, of course also insulating layers are present and furthermore, the shown metallic layers do not have to be the only electrically conductive layers.

As shown in the perspective view of Figure 3, a VCSEL array 100 having an electrically conductive substrate 102 is connected to a ground plane layer 108. On an active chip surface of the VCSEL array 100, contact pads (not visible in this figure) are provided for contacting the anode and cathode of the individual laser diodes. In particular, each signal line 104 is connected to an anode of a VCSEL. On the other hand, each ground line 106 is connected to a cathode terminal of a VCSEL.

According to the present invention, the ground lines 106 have a significantly lower impedance than the signal lines 104. In the embodiment shown in Figure 3, this is firstly achieved by choosing the dimensions of the leads in a way that the signal lines 104 are significantly narrower than the ground lines 106. Furthermore, each of the ground lines 106 is connected to the underlying ground plane layer by means of a via contact 118.

A driver array 120 to which the ground lines 106 and the signal lines 104 are connected may symbolize either a directly soldered or press fitted integrated circuit (IC), or a connector for attaching respective wires.

By means of the arrangement according to the present invention, the signal line impedance is not influenced by the distance between the signal line 104 and the ground line 106, but only by the distance to the underlying ground plane layer. This distance may for instance be as small as 10 µm, whereas the distance between the signal line 104 and the ground line 106 may be 60 µm. The ground lines 106 are at least five times wider than the signal lines 104. For instance, the signal lines may have a width of about 20 µm, whereas the ground lines have a width of 110 µm. The impedance value of the signal lines 104 is set by the width of the signal lines and their distance to the ground plane layer to a value of about 50 Ohm. Of course, these particular dimensions are only examples of the values that can be used to implement the idea according to the present invention.

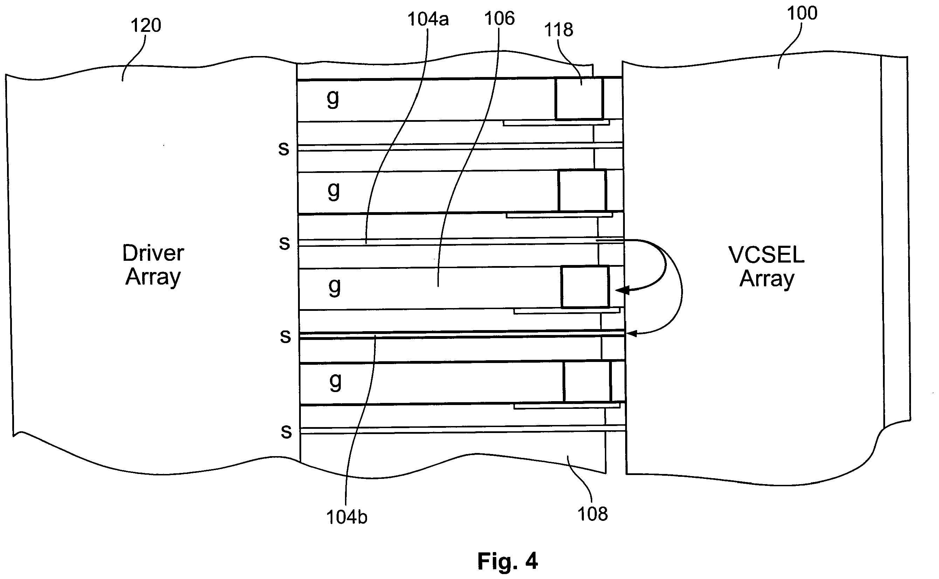

By using this particular construction, the impedance for the signal return path is significantly reduced and thus a much lower amount of the aggressor return current passes through the VCSEL of the victim channel. This is illustrated in Figure 4, which is a detail of Figure 3. As can be seen from this figure, the main part of the return signal is guided by the ground line 106 and only a smaller fraction of the energy returns via the adjacent signal path 104b.

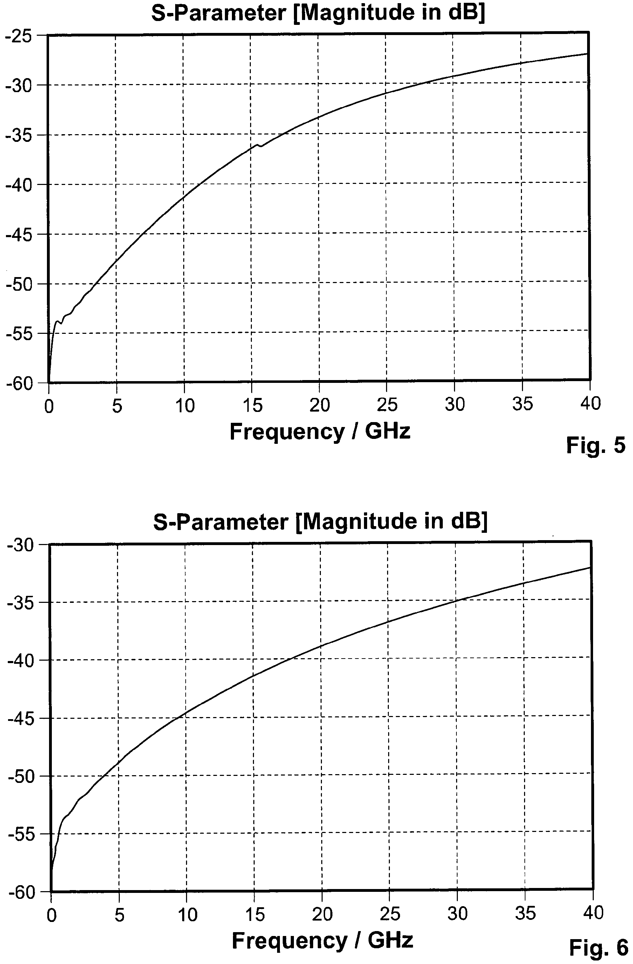

This effect is also mirrored by comparing the s-parameter vs. frequency curves shown in Figures 5 and 6 for the arrangement of Figure 1 and 3, respectively. Each of these s-parameter coupling coefficients are shown corresponding to the strongest cross talk from the driver output to the neighboring channel VCSEL input.

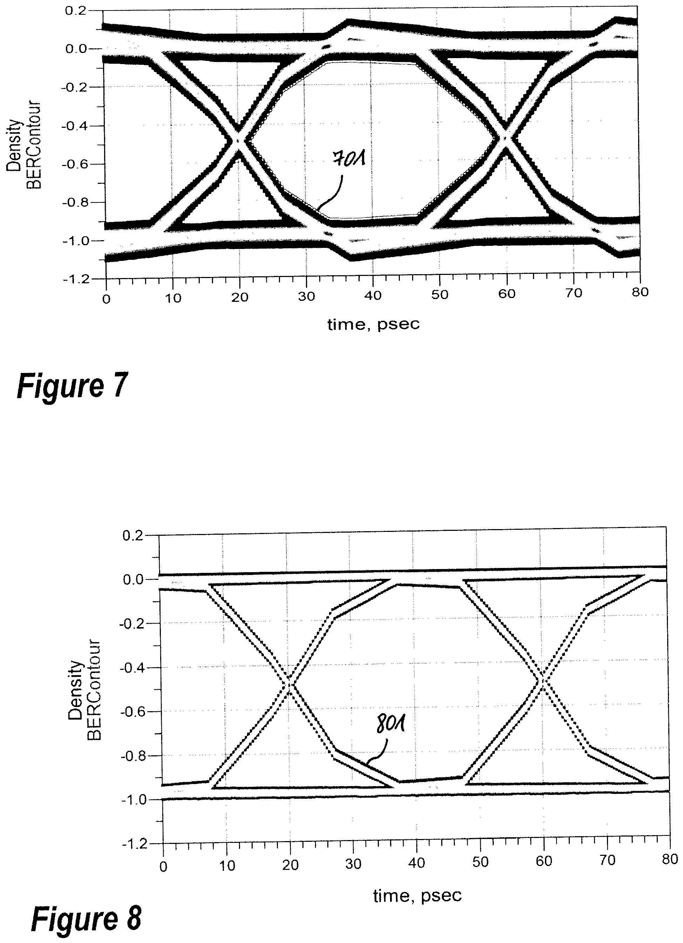

Figures 7 and 8 show in a comparison the respective EYE diagrams for a 25 Gbps bit rate and a bit error rate of BER = 10⁻¹². As shown in Figure 7, the arrangement of Figure 1 generates about 4 ps or 0.1 UI jitter for a driver VCSEL channel with all aggressor channels activated, whereas according to Figure 8 the cross talk generates below 1.8 ps or 0.05 UI jitter in the EYE diagram. The outlines 701 and 801, respectively, correspond to BER = 10⁻¹².

Consequently, both the coupling between neighboring channels and the jitter due to the cross talk are significantly reduced when comparing the interconnect solution according to the present invention to the case with equal impedances according to Figure 1. Thus, the interconnect according to the present invention reduces crosstalk level between the channels, allowing longer transmission links and yielding a better quality of the signal.

**Reference Numerals:**

| **Reference Numeral** | **Description** |
|---|---|
| 100 | VCSEL array, optical unit |
| 102 | electrically conductive substrate of VCSEL array |
| 104 | signal line |
| 106 | ground line |
| 108 | ground plane layer |
| 110 | interconnects between PIN diode array and TIA |
| 112 | channel victim |
| 114 | first transmitter aggressor |
| 116 | second transmitter aggressor |
| 118 | connection point, via |
| 120 | driver array, electronic unit |
| 701,801 | outlines in EYE diagram corresponding to a bit error rate of BER = 10⁻¹² |

## Claims

1. Interconnect structure adapted to couple an electronic unit (120) adapted to output and/or receive electric signals, and an optical unit (100) adapted to convert said electric signals into optical signals and/or vice versa,
said interconnect structure comprising an electrically insulating substrate and at least one pair of transmission leads (104, 106) coupled between said electronic unit (120) and said optical unit (100), a first lead (104) being a signal line, a second lead (106) being a ground line,
**characterized in that**
said second lead (106) has a width over its entire length that is at least five times larger than any width of said first lead (104) in order to have a lower impedance than said first lead (104).

2. Interconnect structure according to claim 1, wherein said electrical interconnect comprises a ground plane layer (108) underlying said at least one second lead (106), wherein said second lead (106) is connected to said ground plane layer (108) by means of at least one connection point (118).

3. Interconnect structure according to claim 2, wherein at least one connection point (118) comprises a via.

4. Interconnect structure according to one of the preceding claims, wherein the impedance of said first lead (104) is defined by its width and a distance to a ground plane layer (108).

5. Interconnect structure according to one of the preceding claims, further comprising a connector contact region that is formed to mount an electrical connector thereon.

6. Interconnect structure according to one of the preceding claims, being formed to mount an optical receiver unit and a second electronic circuit for processing electric signals generated by said optical receiver, said interconnect structure further comprising at least one pair of receiver leads (110) for connecting the optical receiver unit and the second electronic circuit to each other.

7. Optoelectronic module comprising an electronic unit (120) for outputting and/or receiving electric signals, and an optical unit (100) for converting said electric signals into optical signals and/or vice versa,
an electrical interconnect structure according to one of the preceding claims adapted to connect the electronic unit (120) and the optical unit (100) to each other,
said optical unit (100) comprising an electrically conducting substrate (102).

8. Optoelectronic module according to claim 7, said electronic unit (120) comprising a driver circuit, and said optical unit comprising at least one optical sender.

9. Optoelectronic module according to claim 8, further comprising at least one optical receiver and an amplifying circuit for amplifying output signals of the at least one optical receiver.

10. Optoelectronic module according to claim 9, said optical receiver comprising an array of positive intrinsic negative (PIN) photo diodes.

11. Optoelectronic module according to claim 10, said amplifying circuit comprising a transimpedance amplifier (TIA) array.

12. Optoelectronic module according to one of the claims 7 to 11, wherein said optical unit comprises an array of vertical cavity surface emitting lasers (VCSEL).

13. Optoelectronic module according to claim 12, comprising a 12-channel VCSEL array and a 12-channel low power driver.

## Patentansprüche

1. Verbindungsstruktur, die zur Kopplung einer elektronischen Einheit (120), die zur Ausgabe und/oder zum Empfang elektrischer Signale ausgebildet ist, und einer optischen Einheit (100), die zur Umwandlung der elektrischen Signale in optische Signale und/oder umgekehrt ausgebildet ist, vorgesehen ist,
wobei die Verbindungsstruktur ein elektrisch isolierendes Substrat und mindestens ein Paar aus Übertragungsleitungen (104, 106) aufweist, die zwischen der elektrischen Einheit (120) und der optischen Einheit (100) angeschlossen sind, wobei ein erste Leitung (104) eine Signalleitung und eine zweite Leitung (106) eine Masseleitung ist,
**dadurch gekennzeichnet, dass**
die zweite Leitung (106) eine Breite über ihre gesamte Länge hinweg hat, die mindestens fünfmal größer als jede Breite der ersten Leitung (104) ist, um einen geringeren Widerstand als die erste Leitung (104) zu haben.

2. Verbindungsstruktur nach Anspruch 1, wobei die elektrische Verbindung eine Erdungsebenenschicht (108), die unter der mindestens einen zweiten Leitung (106) liegt, wobei die zweite Leitung (106) mit der Erdungsebenenschicht (108) durch mindestens einen Verbindungspunkt (118) verbunden ist.

3. Verbindungsstruktur nach Anspruch 2, wobei mindestens ein Verbindungspunkt (118) eine Durchführung aufweist.

4. Verbindungsstruktur nach einem der vorhergehenden Ansprüche, wobei die Impedanz der ersten Leitung (104) durch ihre Breite und einen Abstand zu einer Erdungsebenenschicht (108) festgelegt ist.

5. Verbindungsstruktur nach einem der vorhergehenden Ansprüche, die ferner ein Verbinder-Kontaktgebiet aufweist, das ausgebildet ist, um darauf einen elektrischen Verbinder zu befestigen.

6. Verbindungsstruktur nach einem der vorhergehenden Ansprüche, die zur Montage einer optischen Empfängereinheit und einer zweiten elektronischen Schaltung zur Verarbeitung elektrischer Signale, die von dem optischen Empfänger erzeugt sind, ausgebildet ist, wobei die Verbindungsstruktur ferner mindestens ein Paar aus Empfängerleitungen (110) zur gegenseitigen Verbindung der optischen Empfängereinheit und der zweiten elektronischen Schaltung aufweist.

7. Optoelektronisches Modul mit einer elektronischen Einheit (120) zur Ausgabe und/oder zum Empfang elektrischer Signale und einer optischen Einheit (100) zur Umwandlung der elektrischen Signale in optische Signale und/oder umgekehrt,
einer elektrischen Verbindungsstruktur nach einem der vorhergehenden Ansprüche, die ausgebildet ist, die elektronische Einheit (120) und die optische Einheit (100) miteinander zu verbinden,
wobei die optische Einheit (100) ein elektrisch leitendes Substrat (102) aufweist.

8. Optoelektronisches Modul nach Anspruch 7, wobei die elektronische Einheit (120) eine Treiberschaltung umfasst und wobei die optische Einheit mindestens einen optischen Sender aufweist.

9. Optoelektronisches Modul nach Anspruch 8, das ferner mindestens einen optischen Empfänger und eine Verstärkerschaltung zur Verstärkung von Ausgangssignalen des mindestens einen optischen Empfängers aufweist.

10. Optoelektronisches Modul nach Anspruch 9, wobei der optische Empfänger eine Anordnung aus Positiv-Intrinsik-Negativ- (PIN-) Fotodioden aufweist.

11. Optoelektronisches Modul nach Anspruch 10, wobei die Verstärkerschaltung eine Transimpedanzverstärker- (TIA-) Anordnung aufweist.

12. Optoelektronisches Modul nach einem der Ansprüche 7 bis 11, wobei die optische Einheit eine Anordnung aus oberflächenemittierenden Lasern mit vertikaler Kavität (VCSEL) aufweist.

13. Optoelektronisches Modul nach Anspruch 12 mit einer 12-Kanal-VCSEL-Anordnung und einem 12-Kanal-Niedrigleistungs-Treiber.

## Revendications

1. Structure d'interconnexion adaptée pour accoupler une unité électronique (120) adaptée pour émettre ou recevoir des signaux électriques, et une unité optique (100) adaptée pour convertir lesdits signaux électriques en signaux optiques et/ou vice versa,
ladite structure d'interconnexion comprenant un substrat électriquement isolant et au moins une paire de broches de connexion de transmission (104, 106) accouplées entre ladite unité électronique (120) et ladite unité optique (100), une première broche de connexion (104) étant une ligne de signal, une seconde broche de connexion (106) étant une ligne de terre,
**caractérisée en ce que**
ladite seconde broche de connexion (106) présente une largeur par-dessus sa longueur entière qui est au moins cinq fois plus grande que n'importe quelle largeur de ladite première broche de connexion (104) afin d'avoir une impédance plus faible que ladite première broche de connexion (104).

2. Structure d'interconnexion selon la revendication 1, ladite interconnexion électrique comprenant une couche plan de masse(108) sous-jacente à ladite au moins une seconde broche de connexion (106), où ladite seconde broche de connexion (106) est connectée à ladite couche de plan terre (108) à l'aide d'au moins un point de connexion (118).

3. Structure d'interconnexion selon la revendication 2, au moins un point de connexion (118) comprenant un trou traversant.

4. Structure d'interconnexion selon l'une quelconque des revendications précédentes, l'impédance de ladite première broche de connexion (104) étant définie par sa largeur et une distance jusqu'à une couche de plan terre (108).

5. Structure d'interconnexion selon l'une quelconque des revendications précédentes, comprenant en outre une région de contact de connecteur qui est formée pour monter dessus un connecteur électrique.

6. Structure d'interconnexion selon l'une quelconque des revendications précédentes, qui est formée pour monter une unité récepteur optique et un second circuit électronique pour traiter les signaux électriques produits par ledit récepteur optique, ladite structure d'interconnexion comprenant en outre au moins une paire de broches de connexion réceptrices (110) pour connecter l'unité récepteur optique et le second circuit électronique l'un à l'autre.

7. Module optoélectronique comprenant une unité électronique (120) pour émettre et/ou recevoir des signaux électriques, et une unité optique (100) destinée à convertir lesdits signaux électriques en signaux optiques et/ou vice versa,
une structure d'interconnexion électrique selon l'une quelconque des revendications précédentes adaptée pour connecter l'unité électronique (120) et l'unité optique (100) l'une à l'autre, ladite unité optique (100) comprenant un substrat électriquement conducteur (102).

8. Module optoélectronique selon la revendication 7, ladite unité électronique (120) comprenant un circuit de commande, et ladite unité optique comprenant au moins un émetteur optique.

9. Module optoélectronique selon la revendication 8, comprenant en outre au moins un récepteur optique et un circuit d'amplification pour amplifier les signaux de sortie du au moins un récepteur optique.

10. Module optoélectronique selon la revendication 9, ledit récepteur optique comprenant une rangée de photodiodes à zone intrinsèque intercalée entre une région fortement dopée P et une autre fortement dopée N (PIN).

11. Module optoélectronique selon la revendication 10, ledit circuit d'amplification comprenant une rangée d'amplificateurs à transimpédance (TIA).

12. Module optoélectronique selon l'une quelconque des revendications 7 à 11, ladite unité optique comprenant une rangée de lasers à cavité verticale et à émission par la surface (VCSEL).

13. Module optoélectronique selon la revendication 12, comprenant une rangée VCSEL à 12 canaux et un dispositif de commande de faible puissance à 12 canaux.
